**Europäisches Patentamt**

**European Patent Office**

**Office européen des brevets**

(11) Veröffentlichungsnummer: **0 097 228**
**A1**

## (12) EUROPÄISCHE PATENTANMELDUNG

(21) Anmeldenummer: 83103338.6

(22) Anmeldetag: 06.04.83

(51) Int. Cl.³: **H 05 K 7/14**

(30) Priorität: 21.04.82 GB 8211565

(43) Veröffentlichungstag der Anmeldung:
04.01.84 Patentblatt 84/1

(84) Benannte Vertragsstaaten:
AT BE CH DE FR GB IT LI NL SE

(71) Anmelder: Rittal-Werk Rudolf Loh GmbH & Co. KG
Auf dem Stützelberg
D-6348 Herborn(DE)

(72) Erfinder: Erlam, David Paul
"Spindlewood" Partridge Down Oliver's Battery
Winchester Hampshire(GB)

(72) Erfinder: Carr, Arthur Edgar
Chanson Highfield Avenue Twyford
Winchester Hampshire(GB)

(74) Vertreter: Vogel, Georg
Hermann-Essig-Strasse 35 Postfach 105
D-7141 Schwieberdingen(DE)

(54) Ein- und Ausziehvorrichtung für mit Steckerleisten versehenen Karten elektrischer Baugruppen.

(57) Die Ein-, Ausziehvorrichtung besteht aus einem im Bereich der vorderen unteren Ecke jeder Karte (30) zweiarmigen mittels Stift (34) drehbar gelagertem zweiarmigen Hebel (32) aus einer schräg zur Vorderkante der Karte stehenden Ausgangsstellung in eine and der Vorderkante der Karte anliegende Verriegelungsstellung verschwenkbar ist, wobei der kurze Hebelarm (40) in ein Haken-Fersen-Ausgestaltung (53) ausläuft, bei dem beim Einschieben der Karte und Hochklappen des Hebels (32) in die Verriegelungsstellung der Haken (54) in eine rahmenfeste Aufnahme einfürbar ist und sich entgegen der Einschubrichtung der Karte in dieser Aufnahme abstützt und bei dem die Ferse (56) bei Abklappen des Habels (32) in die Ausgangstellung und Herausziehen der Karte sich an einer rahmen- festen Frontfläche abstützt, und wobei der Hebel (32) über kreisbogenförmige Schlitze (36) an dem Stift (34) verstellbar gelargert ist, wobei in der Ausgangsstellung des Hebels (32) der Stift (34) an den oberen Enden der Schlitze (36) anliegt und in der Verriegelungsstellung in den Bereich der unteren Enden der Schlitze (36) verstellt ist.

Fig.4

A 4902                  - 1 -                    0097228

Kartenrahmen mit Kartenführungen und
darin geführten Karten

Die Erfindung betrifft einen Kartenrahmen mit einer Anzahl von Paaren
senkrecht aufeinander ausgerichteter Kartenführungen zur Aufnahme von
mit Steckerleisten versehenen Karten, bei dem jedem Paar von Kartenführungen eine die Steckerleiste aufnehmende Steckbuchsenleiste zugeordnet
ist, bei dem im Bereich der vorderen untern Ecke jeder Karte ein zweiarmiger, mittels Stift drehbar gelagerter zweiarmiger Hebel aus einer
schräg zur Vorderkante der Karte stehenden Ausgangsstellung in eine an
der Vorderkante der Karte anliegende Verriegelungsstellung verschwenkbar ist, wobei der kurze Hebelarm in eine Haken-Fersen-Ausgestaltung
ausläuft, bei dem beim Einschieben der Karte und Hochklappen des Hebels
in die Verriegelungsstellung der Haken in eine rahmenfeste Aufnahme
einführbar ist und sich entgegen der Einschubrichtung der Karte in
dieser Aufnahme abstützt und bei dem die Ferse beim Abklappen des
Hebels in die Ausgangsstellung und Herausziehen der Karte sich an einer
rahmenfesten Frontfläche abstützt.

Ein Kartenrahmen dieser Art ist durch die US-A 40 83 616 bekannt. Der
Hebel an der Karte dient dazu, die Karte unter Überwindung der Einsteckkraft der Steckerleiste und der Steckbuchsen in die Einschubendstellung
zu bringe, wobei die Übersetzung an dem zweiarmigen Hebel das Einschieben der Karte unter Herstellung der Verbindung zwischen der Steckerleiste und der Steckbuchsenleiste erleichtert. Bei der Einschubbewegung
stützt sich beim Hochklappen des Hebels der Haken des Hebels in der
rahmenfesten Aufnahme ab und der Hebel überträgt über den Stift die
Einschubkraft, entsprechend übersetzt auf die Karte. Ähnlich verhält es

A 4902　　　　　　　- 2 -　　　　　0097228

sich beim Herausziehen der Karte und dem damit verbundenen Aufheben der Verbindung zwischen der Steckerleiste und der STeckbuchsenleiste. Beim Herausziehen der Karte stützt sich die Ferse des Hebels an der rahmenfesten Frontseite ab und es wird beim Abklappen des Hebels in die Ausgangsstellung eine entsprechend übersetzte Auszugskraft auf die Karte übertragen.

Bei diesem bekannten Kartenrahmen ist die Einschubendstellung der Karte nur dadurch gesichert, daß federnde Rastelemente des Hebels in der Verriegelungsstellung des Hebels sich an beiden Seiten der Karte klemmend abstützen. Durch entsprechende Krafteinwirkung auf die Karte kann diese Klemmverbindung jedoch überwunden werden, so daß die Karte herausgezogen werden kann.

Wie die US-A 43 13 150 zeigt, kann die Verriegelungsstellung des Hebels auch durch eine Rastverbindung verbessert werden. Dazu muß aber die Karte mit einem Loch versehen sein, in das Ansätze des Hebels einrasten.

Es ist Aufgabe der Erfindung, einen Kartenrahmen der eingangs erwähnten. Art so zugestalten, daß die Karten in den Einschubendstellungen ohne Löcher in der Karte eindeutig arretiert werden, so daß selbst bei großen Zugkräften an der Karte die Einschubendstellung nicht aufgehoben wird.

Diese Aufgabe wird nach der Erfindung dadurch gelöst, daß der Hebel über kreisbogenförmige Schlitze an dem Stift der Karte zusätzlich verstellbar gelagert ist, wobei in der Ausgangsstellung des Hebels der Stift an den oberen Enden der Schlitze anliegt und in der Verriegelungsstellung in den Bereich der unteren Enden der Schlitze verstellt ist und daß in der Ausgangsstellung und der Verriegelungsstellung des Hebels der Stift in Einführrichtung der Karte jeweils vor dem Haken angeordnet ist.

Allein durch diese besondere Lagerung des Hebels und Anordnung der Lagerstelle an der Karte wird eine eindeutige Arretierung der Karte in der Verriegelungsstellung des Hebels erreicht. Beim Ziehen an der Vorderkante der Karte kann sich der Hebel nicht verschwenken und die Wirkverbindung zwischen dem Haken des Hebels und der rahmenfesten Aufnahme aufheben. Selbst bei großer Zugkraft an der Karte hält diese ihre Einschubendstellung bei.

Eine unverkantete Kraftübertragung von dem Hebel auf die Karte wird nach einer Ausgestaltung dadurch erreicht, daß der Hebel im Querschnitt U-förmig ist und die Vorderkante der Karte beidseitig umgreift und daß der kurze Hebelarm beidseitig in eine Haken-Fersen-Ausgestaltung ausläuft.

Nach einer Ausgestaltung ist vorgesehen, daß die Aufnahmen für die Haken in einer Nase der Kartenführung eingebracht sind und daß die Stirnseite der Nase die Frontfläche zur Abstützung der Fersen bildet. Diese Ausgestaltung hat den Vorteil, daß die Lage der Aufnahmen und der Frontfläche eine eindeutige Lage zur Kartenführung einnehmen.

Die Auslegung der Schlitze in dem Hebel ist vorteilhafterweise so, daß in der Ausgangsstellung des Hebels die oberen Enden der kreisbogenförmigen Schlitze den kleinsten Abstand zu der Vorderkante der Karte einnehmen und daß in der Verriegelungsstellung des Hebels die unteren Enden der Schlitze den kleinsten Abstand zu der Vorderkante der Karte einnehmen, um definierte Stellungen zur Karte einnehmen zu können und die eindeutige Verriegelung zu gewährleisten.

Ist nach einer weiteren Ausgestaltung vorgesehen, daß die Seitenwände des U-förmigen Hebels im Bereich des freien Endes des langen Hebelarmes Teile mit reduzierter Wandstärke aufweisen und daß die einander zugekehrten Innenflächen dieser Teile mit Ansätzen versehen sind, deren Abstand kleiner ist als die Dicke der Karte, dann kann der Hebel auch bei einer aus dem Kartenrahmen herausgezogenen Karte an der Vorderkante der Karte festgelegt werden.

Die Erfindung wird anhand eines in den Zeichnungen dargestellten Ausführungsbeispiels näher erläutert. Es zeigt:

Fig. 1 eine perspektivische Vorderansicht eines Kartenrahmens,

Fig. 2 eine perspektivische Rückansicht eines Teils des Kartenrahmens mit einer Karteneinschieb- und -auszieheinrichtung,

Fig. 3 eine Seitenansicht eines Hebels der Einrichtung nach Fig. 2 in Richtung des Pfeiles III nach Fig. 2 gesehen,

Fig. 4 eine Seitenansicht mit einer teilweise eingeschobenen Karte unmittelbar vor der Karteneinschiebendstellung,

Fig. 5 eine Seitenansicht der Einrichtung im Verlaufe der Einschiebbewegung,

Fig. 6 eine Seitenansicht der Einrichtung bei vollständig eingeschobener Karte,

Fig. 7 eine Seitenansicht der Einrichtung mit teilweise ausgezogener Karte,

Fig. 8 eine Seitenansicht der Einrichtung mit vollständig ausgezogener und teilweise entfernter Karte und

Fig. 9 eine der Fig. 2 entsprechende Ansicht mit einer Kartenführung einer abgewandelten Karteneinschieb- und -auszieheinrichtung.

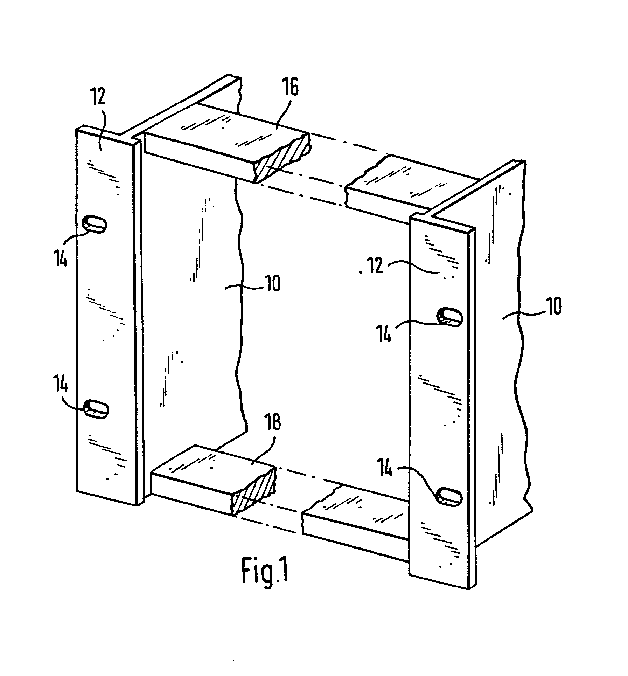

Fig. 1 zeigt einen Kartenrahmen, der aus zwei im Druckgußverfahren hergestellten Seitenplatten 10 aus Metall besteht. Diese Seitenplatten 10 sind vorzugsweise, aber nicht unbedingt, von identischer Auslegung. Die Seitenplatten 10 besitzen Frontbefestigungsflansche 12, die einstückig angeformt sind. Mittels nicht dargestellter Schrauben, die durch die Löcher 14 in den Frontbefestigungsflanschen 12 eingeführt werden, kann der Kartenrahmen (oder das Untergestell) in ein Gestell oder ein anderes Gehäuse nach bekannter Art eingebaut werden.

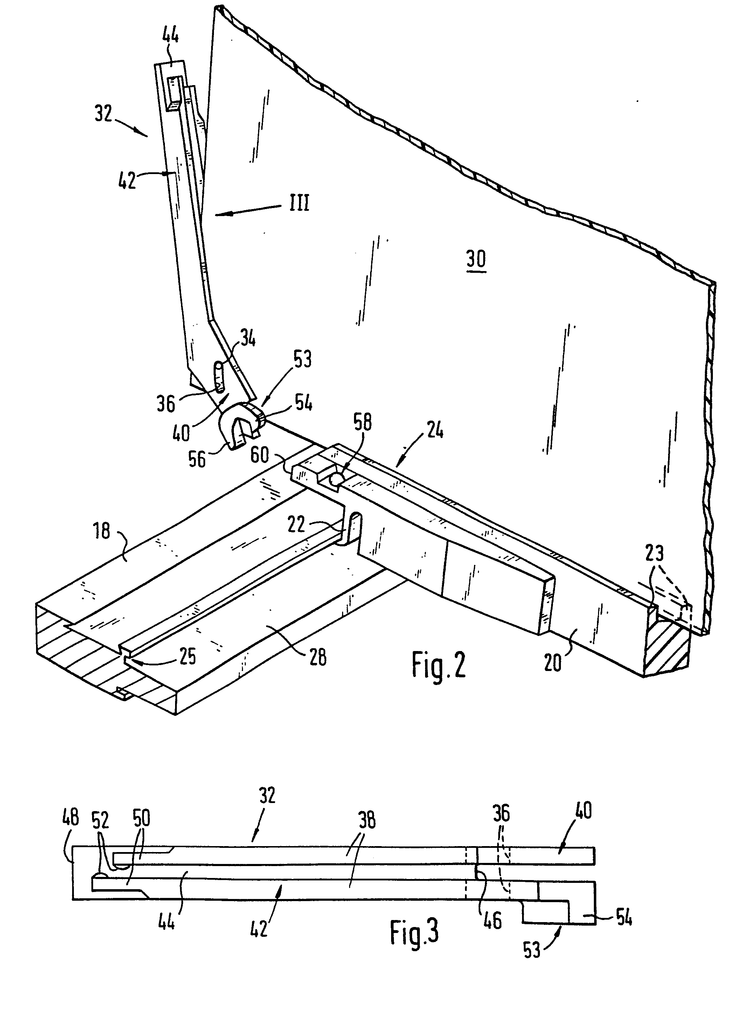

Die Seitenplatten 10 sind in vertikalen Ebenen angeordnet und mittels einer Vielzahl von horizontal gerichteten Querstreben, die an den Seitenplatten befestigt sind, miteinander verbunden. Es sind nur eine obere vordere Querstrebe 16 und eine untere vordere Querstrebe 18 in Fig. 1 gezeigt. Ihre Ausgestaltung ist dabei der Einfachheit halber etwas vereinfacht. Der Kartenrahmen enthält obere und untere hintere Querstreben. Eine Vielzahl von Kartenführungen besitzen nach oben offene, längsgerichtete Kanäle. Die Kanäle werden durch die Seitenwände 23 bestimmt und erstrecken sich von der vorderen unteren Querstrebe bis zur hinteren unteren Querstrebe. Eine solche Kartenführung ist in Fig. 2 mit dem Bezugszeichen 20 gekennzeichnet. Gleiche Kartenführungen mit nach unten offenen Kanälen sind zwischen der vorderen oberen Querstrebe und der hinteren oberen Querstrebe angebracht. Die an den oberen Querstreben und an den unteren Querstreben angebrachten Kartenführungen sind in vertikalen, im Abstand angeordneten Paaren festgelegt, um in bekannter Weise mit elektrischen Stromkreisen bestückte Karten aufzunehmen. Die oberen Querstreben und die oberen Kartenführungen können im wesentlichen den unteren Querstreben und den unteren Kartenführungen gleichen, mit Ausnahme ihrer Ausrichtung, so daß nur die unteren Querstreben und unteren Kartenführungen beschrieben werden müssen. Die unteren und oberen Querstreben müssen nicht unbedingt an dem unteren und oberen Ende des Kartenrahmens befestigt sein. Es genügt, wenn die oberen Querstreben näher am oberen Ende des Kartenrahmens angebracht sind als die unteren Querstreben. Der Kartenrahmen nach Fig. 1 ist so aufgebaut, wie er in der britischen Patentanmeldung No. 81 19 943 beschrieben ist.

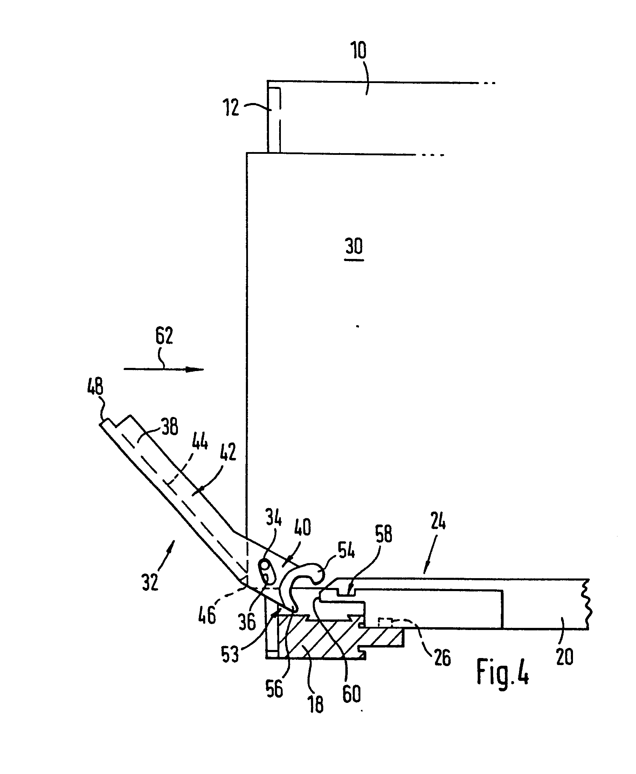

Wie aus der Fig. 2 für das vordere Ende am besten zu ersehen ist, wird jedes Ende der Kartenführung 20 mittels federnden Verlängerungen 22 einer Nase 24 der Kartenführung 20 in einer Nut 25 der Querstrebe 18 gehalten. Die Nase 24 ist an einer gewünschten Stelle entlang der Länge der Querstrebe 18 gehalten und zwar mit Hilfe einer Aufnahme 26 (Fig. 4) in der Unterseite der Nase 24, die einen ausgewählten Ansatz einer Vielzahl von imAbstand angeordneten Ansätzen aufnimmt. Diese Ansätze sind in regelmäßigen Abständen mit einer gewünschten Teilung entlang der Oberfläche 28 der Querstrebe 18 angeordnet. Das andere Ende der Kartenführung 20 ist mit einer ähnlichen Nase 24 versehen und in gleicher Weise an der hinteren unteren Querstrebe gehalten. Die oberen Kartenführungen sind in gleicher Weise an den oberen Querstreben gehalten. Die gesamte Einrichtung ist so aufgebaut, wie in der britischen Patentanmeldung No. 81 19 939 beschrieben ist.

Aus Fig. 2 ist weiterhin eine Karte 30 mit elektrischem Stromkreis zu entnehmen, die teilweise in den Kartenrahmen eingeführt ist. Die untere Kante der Karte 30 ist in die untere Kartenführung 20 eingeschoben und die obere Kante wird in gleicher Weise in dem Kanal der zugeordneten oberen Kartenführung gehalten. An der hinteren Kante trägt die Karte 30 eine Steckerleiste, die bei vollständig eingeschobener Karte 30 in bekannter Weise in eine Steckbuchsenleiste eingesteckt wird, die an der Rückseite des Kartenrahmens, z.B. zwischen den hinteren Querstreben oder zwischen weiteren, für diesen Zweck vorgesehenen Querstreben, befestigt ist.

Ein zweiarmiger Hebel 32, der als einstückiges Kunststoffteil ausgebildet sein kann, ist im Bereich der vorderen unteren Ecke der Karte 30 drehbar befestigt und zwar mittels eines Stiftes 34, der in der Karte 30 festgelegt ist und sich von beiden Oberflächen der Karte 30 aus in bogenförmige Schlitze 36 erstreckt, die in den beiden hochstehenden Seitenwänden 38 des Hebels 32 eingebracht sind. Diese Drehlagerung bestimmt einen ersten relativ kurzen Hebelarm 40 und einen zweiten relativ langen Hebelarm 42.

Entlang des Hebelarmes 42 sind die hochstehenden Seitenwände 38 mittels eines Steges 44 miteinander verbunden. Der Steg 44 endet mit einer Kante 46 in der Nähe der Schlitze 36, wobei eine Ausgangsstellung des Hebels 32 durch Anschlag der Kante 46 an der Vorderkante der Karte 30 definiert ist, wie Fig. 2 zeigt.

Am freien Ende des Hebelarmes 42 und in kleinem Abstand von dem anderen Ende 48 des Steges 44 sind die Seitenwände 38 mit Teilen 50 von reduzierter Wandstärke verstehen und daher entsprechend elastisch und auslenkbar. Die Elastizität ist dabei vorzugsweise durch den ganz aus elastischem Kunststoff gespritzten Hebel 32 gegeben. Die einander zugekehrten Oberflächen der Teile 50 sind mit Ansätzen 52 versehen.

Am freien Ende des kurzen Hebelarmes 40 des Hebels 32 ist eine der Seitenwände 38 mit einer Ausgestaltung 53 versehen, die im wesentlichen den Kopf eines Haken- oder Schraubenschlüssels bildet. Die Ausgestaltung 53 weist einen Haken oder eine Klaue 54 und eine Ferse 56 auf. Der Haken 54 kann mit einer Aufnahme 58 in der Nase 24 der Kartenführung 20 in Eingriff gebracht werden. Die Ferse 56 kann mit einer Endfläche 60 der Nase 24 in Wirkverbindung gebracht werden.

Die eben anhand der Fig. 2 und Fig. 3 beschriebene Einrichtung kann zum Einschieben der Krte benützt werden, d.h. zur Ausführung der letzten Stufe des Einschiebevorganges und zur Herstellung der Verbindung zwischen der Steckerleiste und der STeckbuchsenleiste, um die Karte mit der Hebelbetätigung einzudrücken und dabei die Einsteckkraft für die Steckleisten/Steckbuchsenleisten-Kombination in genau definierter Weise aufzubringen und um die Karte herauszuziehen, d.h. die Verbindung zwischen der Steckerleiste und der Steckbuchsenleiste zu lösen. Dabei wird durch die Hebelbetätigung wieder die zur Trennung der Steckerleiste und der STeckbuchsenleiste erforderliche Kraft in vorgegebener Weise aufgebracht. Außerdem dient die Einrichtung dazu, die vollständig eingesteckte Karte festzuhalten. Die Wirkungsweise der Einrichtung zur Durchführung dieser drei Funktionen wird nun anhand der Fig. 4 bis 8 näher erläutert.

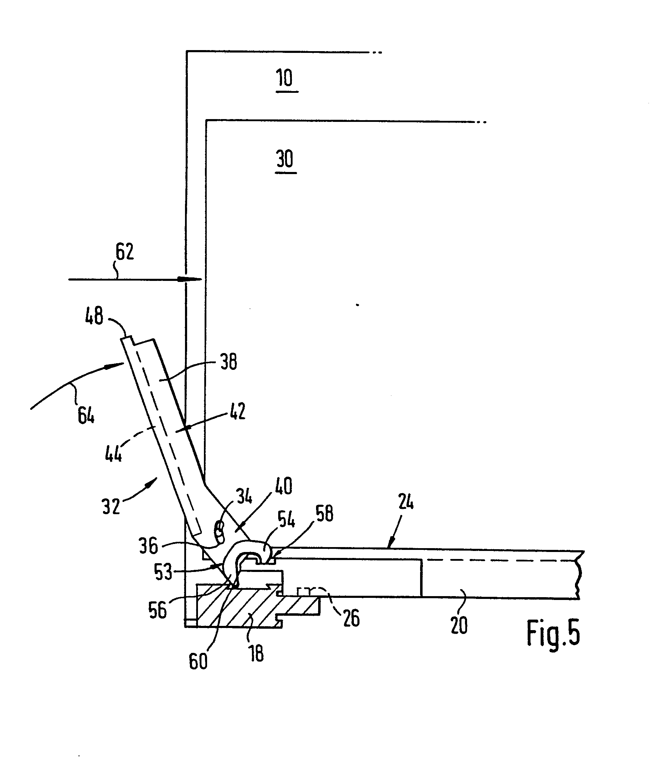

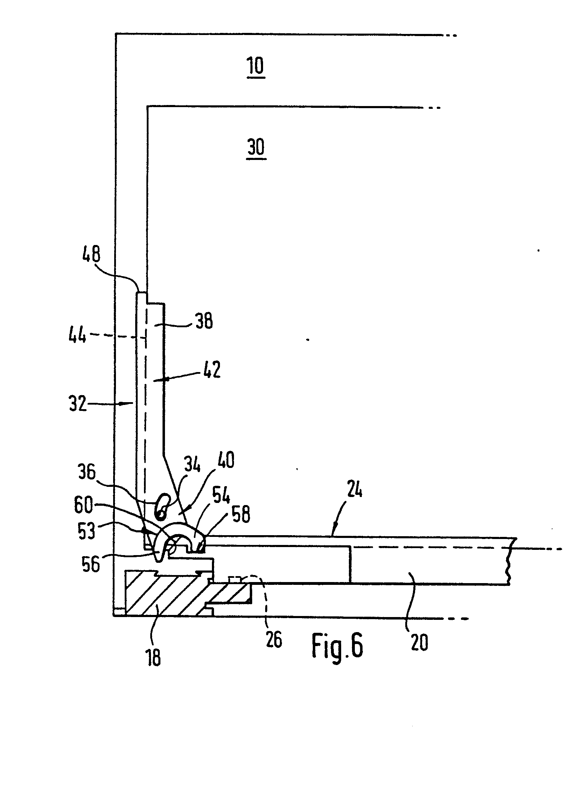

Fig. 4 zeigt die Einrichtung in einer Stellung, die sie einnimmt, wenn die Karte über den größten Teil des Weges in den Kartenrahmen eingeschoben ist, der Einsteckvorgang jedoch noch nicht begonnen hat. Der Hebel 32 nimmt die beschriebene Ausgangsstellung ein, in der der Stift 34 am oberen Ende der Schlitze 36 anliegt. Die Winkelstellung des Hebels 32 wird durch die relative Lage der Kante 46 des Steges 44 und des Stiftes 34 bestimmt. Wenn die Karte 30 in der Richtung des Pfeiles 62 weiter in den Kartenrahmen eingeschoben wird, dann stößt die Ferse 56 an die Frontfläche 60 der Nase 24 an, wie in Fig. 5 gezeigt ist. Dabei beginnt der Hebel 32 sich in der Pfeilrichtung 64 nach Fig. 5 zu drehen und der Haken 54 wird in die Aufnahme 58 eingeführt. Der Stift 34 bewegt sich in den Schlitzen 36 nach unten. Dann wird in Richtung des Pfeiles 64 manuell Kraft auf den Hebel 32 ausgeübt. Da der Haken 54 mit der Aufnahme 58 im Eingriff steht, beginnt sich der ganze Hebel 32 um diesen Eingriffspunkt von Haken 54 und Aufnahme 56 zu drehen, wobei über den Stift 32 auf die Karte 30 eine Kraft zum Einschieben der Karte ausgeübt wird. Die Karte wird dabei unter Überwindung der Einsteckkraft in die Einschubendstellung gebracht, in der die Steckerleiste an der Steckbuchsenleiste anliegt. Die Hebelbetätigung ist dabei so, daß ein beachtlicher mechanischer Vorteil erreicht wird. Der Einsteckvorgang kann in einer fließenden und vorgegebenen Weise durchgeführt werden. Am Ende des Einsteckvorganges nehmen die Teile die in Fig. 6 gezeigte Stellung ein. Der Stift 34 befindet sich am unteren Ende der Schlitze 36 und die Seitenwände 38 legen sich zu beiden Seiten an der Vorderkante der Karte 30 an, wobei der Steg 44 an der Vorderkante der Karte 30 anliegt. Der Abstand der Ansätze 52 (Fig. 3) der Teile 50 der Seitenwände 38 ist etwas kleiner als die Dicke der Karte 30. Da die Teile 50 der Seitenwände 38 elastisch sind, werden sie angelenkt, so daß die Karte 30 zwischen den Ansätzen festgeklemmt wird. Diese Klemmkraft muß überwunden werden, wenn der Hebel 32 in der entgegengesetzten Richtung so weit von der Karte 30 weg verschwenkt wird, daß der Haken 54 und die Aufnahme 58 außer Eingriff kommen und die Karte 30 herausgezogen werden kann. Die Klemmkraft hält also die Karte gegen unbeabsichtigtes Lösen aus der Einschubendstellung fest.

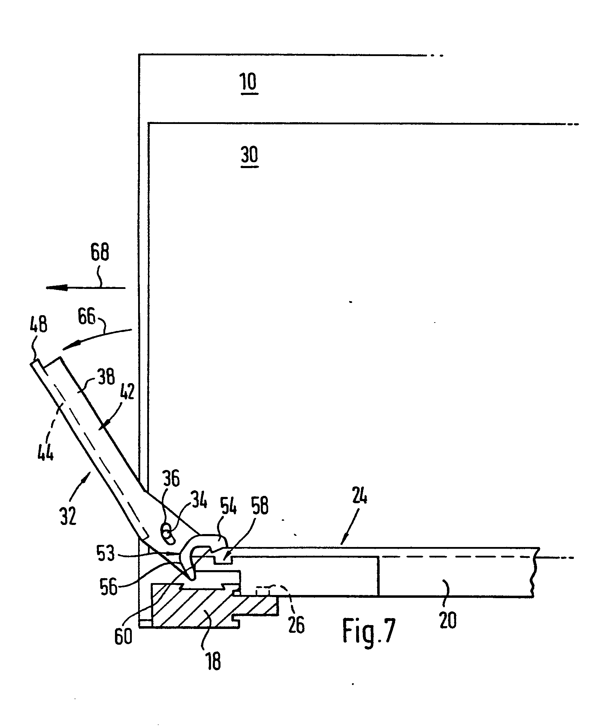

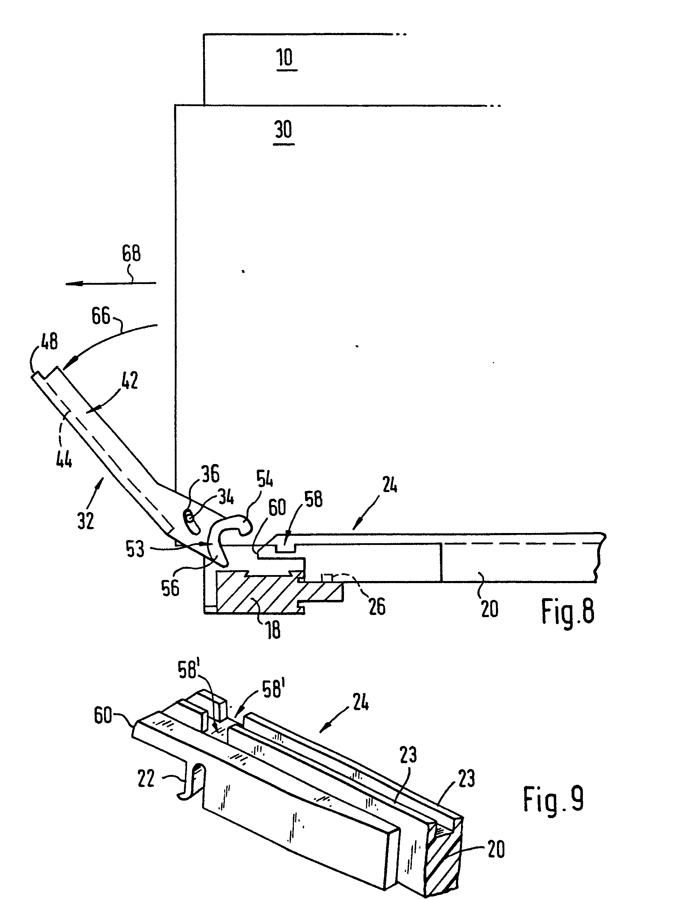

Um die Karte herauszuziehen, wird der Hebel 32 manuell in der entgegengesetzten Richtung, wie durch den Pfeil 66 in Fig. 7 gezeigt ist, verdreht. Der Haken 54 wird außer Eingriff mit der Aufnahme 58 gebracht und der Ausziehvorgang ist freigegeben. Bei der Drehbewegung des Hebels 32 wird die Ferse 56 gegen die Frontfläche 60 der Nase 24 der Kartenführung 20 gedrückt. Dabei wird bei der Hebelbetätigung über den Stift 34 mit beachtlichem mechanischem Vorteil eine Auszugskraft auf die Karte 30 ausgeübt, die in Richtung des Pfeiles 68 in Fig. 7 wirkt. Die Karte 30 wird fließend und in vorgegebener Weise herausgezogen und die Verbindung zwischen der Steckerleiste und der Steckbuchsenleiste aufgehoben. Während dieser Bewegung des Hebels 32 wandert der Stift 34 in den Schlitzen 36 wieder an das obere Ende. Fig. 8 zeigt die Stellung, in der der Ausziehvorgang beendet ist und der Hebel 32 in die Nähe seiner Ausgangsstellung nach Fig. 5 zurückgekehrt ist.

Die Erfindung kann selbstverständlich auch in anderer Weise wie im Ausführungsbeispiel realisiert werden. So kann die Haken-Fersen-Ausgestaltung 53 am freien Ende des Hebelarmes 40 des Hebels 32 auch verdoppelt sein, so daß auf jeder Seite der Karte 30 eine gleiche Ausgestaltung angeordnet ist. Diese Ausgestaltung hat den Vorteil, daß auf den Stift 34 während des Einschieb- und Auszugsvorganges auf beiden Seiten gleiche Kräfte ausgeübt werden. Dadurch werden die Kräfte auf ein Minimum reduziert, die ein Verkanten und Verklemmen der Karte 30 oder eine Bewegung des Hebels 32 zur Aufhebung der Wirkverbindung mit der Karte 30 bewirken könnten. Bei dieser symmetrischen Ausgestaltung werden die Fersen 56 der beiden Ausgestaltungen 53 mit der Frontfläche 60 der Nase 24 der Kartenführung 20 zusammenarbeiten. Die Aufnahme 58 für den Eingriff des Hakens 54 wird jedoch durch ein Paar von Aufnahmen zu beiden Seiten der Karte 30 ersetzt. Wie Fig. 9 zeigt, kann die einzige Aufnahme 58 durch das Paar von Aufnahmen 58' ersetzt werden, die als Ausschnitte oder Schlitze in den Seitenwänden 23 der Kartenführung 20 ausgebildet sind. Wie insbesondere aus den Fig. 2 und 3 zu ersehen ist, müssen die beiden Ausgestaltungen 53 in diesem Falle näher an der Karte 30 angeordnet sein als bei dem Ausführungsbeispiel mit nur einer einzigen Ausgestaltung 53. Die Ausgestaltungen 53 können auf die Seitenwände 38 ausgerichtet sein oder durch die Endteile derselben gebildet werden. Trotz der Anbringung von zwei Ausgestaltungen 53 kann der Hebel 32 dünner sein als im Ausführungsbeispiel nach Fig. 2 und 3.

Rittal - Werk
Rudolf Loh GmbH & Co.KG
Auf dem Stützelberg

6348  H e r b o r n

- 11 -

Ansprüche

1. Kartenrahmen mit einer Anzahl von Paaren senkrecht aufeinander
ausgerichteter Kartenführungen zur Aufnahme von mit Steckerleisten versehenen Karten, bei dem jedem Paar von Kartenführungen
eine die Steckerleiste aufnehmende Steckbuchsenleiste zugeordnet
ist, bei dem im Bereich der vorderen unteren Ecke jeder Karte ein
zweiarmiger, mittels Stift drehbar gelagerter zweiarmiger Hebel
aus einer schräg zur Vorderkante der Karte stehenden Ausgangsstellung in eine an der Vorderkante der Karte anliegende Verriegelungsstellung verschwenkbar ist, wobei der kurze Hebelarm in
eine Haken-Fersen-Ausgestaltung ausläuft, bei dem beim Einschieben der Karte und Hochklappen des Hebels in die Verriegelungsstellung der Haken in eine rahmenfeste Aufnahme einführbar ist
und sich entgegen der Einschubrichtung der Karte in dieser Aufnahme abstützt und bei dem die Ferse beim Abklappen des Hebels in
die Ausgangsstellung und Herausziehen der Karte sich an einer
rahmenfesten Frontfläche abstützt,
dadurch gekennzeichnet,
daß der Hebel (32) über kreisbogenförmige Schlitze (36) an dem
Stift (34) der Karte (30) zusätzlich verstellbar gelagert ist,
wobei in der Ausgangsstellung (Fig. 4) des Hebels (32) der Stift (34) an den oberen Enden der Schlitze (36) anliegt und in der Verriegelungsstellung (Fig. 6) in den Bereich der unteren Enden der Schlitze (36) verstellt ist und

daß in der Ausgangsstellung und der Verriegelungsstellung des Hebels (32) der Stift (34) in Einführrichtung der Karte (30) jeweils vor dem Haken (54) angeordnet ist.

2.    Kartenrahmen nach Anspruch 1,
dadurch gekennzeichnet,
daß der Hebel (32) im Querschnitt U-förmig ist und die Vorderkante der Karte (30) beidseitig umgreift und
daß der kurze Hebelarm (40) beidseitig in eine Haken-Fersen-Ausgestaltung (53) ausläuft.

3.    Kartenrahmen nach Anspruch 1 oder 2,
dadurch gekennzeichnet,
daß die Aufnahmen (58) für die Haken (54) in einer Nase (24) der Kartenführung (20) eingebracht sind und
daß die Stirnseite der Nase (24) die Frontfläche (60) zur Abstützung der Fersen (56) bildet.

4.    Kartenrahmen nach einem der Ansprüche 1 bis 3,
dadurch gekennzeichnet,
daß in der Ausgangsstellung des Hebels (32) die oberen Enden der kreisbogenförmigen Schlitze (36) den kleinsten Abstand zu der Vorderkante der Karte (30) einnehmen und
daß in der Verriegelungsstellung des Hebels (32) die unteren Enden der Schlitze (36) den kleinsten Abstand zu der Vorderkante der Karte (30) einnehmen.

5.    Kartenrahmen nach einem der Ansprüche 1 bis 4,
dadurch gekennzeichnet, daß die Seitenwände (38) des U-förmigen Hebels (32) im Bereich
des freien Endes des langen Hebelarmes (42) Teile (50) mit reduzierter Wandstärke aufweisen und

daß die einander zugekehrten Innenflächen dieser Teile (50) mit
Ansätzen (52) versehen sind, deren Abstand kleiner ist als die
Dicke der Karte (30).

Fig.1

0097228

Fig.2

Fig.3

0097228

Fig.4

Fig.5

Fig.6

Fig.7

0097228

Fig.8

Fig.9

**0097228**

# EUROPÄISCHER RECHERCHENBERICHT

**Europäisches Patentamt**

EP 83 10 3338

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl. 3) |
|---|---|---|---|
| D,A | US-A-4 313 150  (NORTHERN TELECOM LTD.)<br><br>--- | | H 05 K   7/14 |
| D,A | US-A-4 083 616 (STROMBERG-CARLSON CORP.)<br><br>--- | | |
| A | FR-A-2 393 506  (C.G.E.E. ALSTHOM)<br><br>--- | | |
| A | US-A-4 002 381  (BELL TELEPHONE LABORATORIES)<br><br>--- | | |
| A | US-A-4 233 646  (NORTHERN TELECOM LTD.)<br><br>--- | | |
| A | US-A-4 241 966  (THOMAS & BETTS CORP.)<br><br>----- | | **RECHERCHIERTE SACHGEBIETE (Int. Cl. 3)**<br><br>H 05 K<br>H 01 R |

Der vorliegende Recherchenbericht wurde für alle Patentansprüche erstellt.

| Recherchenort | Abschlußdatum der Recherche | Prüfer |
|---|---|---|
| DEN HAAG | 01-08-1983 | SCHUERMANS N.F.G. |

KATEGORIE DER GENANNTEN DOKUMENTEN
X : von besonderer Bedeutung allein betrachtet
Y : von besonderer Bedeutung in Verbindung mit einer anderen Veröffentlichung derselben Kategorie
A : technologischer Hintergrund
O : nichtschriftliche Offenbarung
P : Zwischenliteratur
T : der Erfindung zugrunde liegende Theorien oder Grundsätze

E : älteres Patentdokument, das jedoch erst am oder nach dem Anmeldedatum veröffentlicht worden ist
D : in der Anmeldung angeführtes Dokument
L : aus andern Gründen angeführtes Dokument

& : Mitglied der gleichen Patentfamilie, übereinstimmendes Dokument

EPA Form 1503. 03.82